# EUROPEAN PATENT APPLICATION

(11) **EP 2 312 627 A2**
(43) Date of publication of application: **20.04.2011**
(21) Application number: 10005355.2
(22) Date of filing: 21.05.2010
(51) Int. Cl.: H01L 23/488

(54) **Semiconductor device and on-vehicle AC generator**

(30) Priority: 24.08.2009 JP 2009192720
(71) Applicant: Hitachi, Ltd., Chiyoda-ku Tokyo 100-8280 (JP)
(72) Inventor: Ikeda, Osamu, Tokyo 100-8220 (JP); Matsuyoshi, Satoshi, Tokyo 100-8220 (JP)
(74) Representative: Strehl Schübel-Hopf & Partner

(57) **Abstract**

An object of the present invention is to provide, at low costs, an environmental friendly bonding material for a semiconductor, having sustained bonding reliability even when used at a temperature as high as 200°C or higher for a long period of time, the semiconductor device having a semiconductor element (1), a supporting electrode body (3) bonded to a first face of the semiconductor element (1) via a first bonding member (4), and a lead electrode body (7) bonded to a second face of the semiconductor element (1) supported by the supporting electrode body (3) via a second bonding member (2), the semiconductor device having a Ni-based plating layer and an intermetallic compound layer containing at least one of Cu₆Sn₅ and (Cu,Ni)₆Sn₅ compounds at an interface between the supporting electrode body (3) and the first bonding member (4), and having a Ni-based plating layer and an intermetallic compound layer containing at least one of Cu₆Sn₅ and (Cu,Ni)₆Sn₅ compounds at an interface between the lead electrode body (7) and the second bonding member (2).

## Description

### BACKGROUND OF THE INVENTION

### (1) Field of the Invention

The present invention relates to a semiconductor device and an on-vehicle AC generator.

### (2) Description of the Related Art

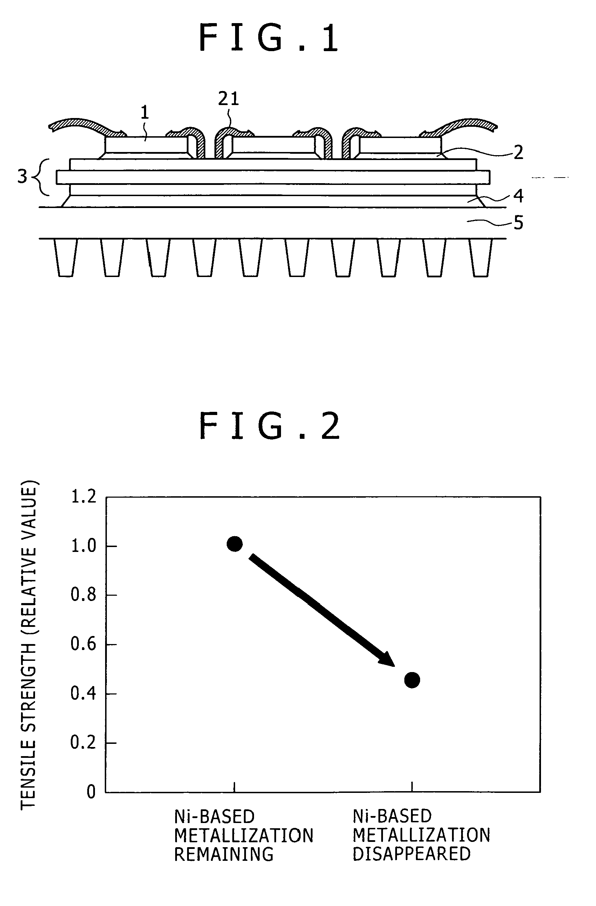

In power electronics products, as shown in Fig. 1, a hierarchical bonding in which a semiconductor element 1 is mounted on a substrate 3, bonded by a bonding member 2, and is further bonded to a supporting member 5 by a bonding member 4 is often provided. Accordingly, In the bonding of the semiconductor element 1, high-lead solders (melting point: about 300°C) having low reactivity with components during fusing of solder and under high heat circumstances have been used in order to avoid the disappearance of a Ni-based metallization (not shown) formed on the supporting member 5 and the bonding face of the semiconductor element 1 for bearing bond strength. However, since the solders have high contents of lead of 85 mass % or higher, development of lead-free semiconductor devices has been required from the perspective of environmental protection. Moreover, even when the hierarchical bonding is not employed, in a case of a large-scale power module, high-lead solders have been conventionally used because the heat capacity of the bonding members is high; an evacuation process is carried out for reducing voids in the bonding portion; and the fusing time of the solder during bonding is prolonged. However, the necessity to deal with lead-free devices has arisen.

Newly developed lead-free solders include Sn-0.7Cu, Sn-3.5Ag, Sn-3Ag-0.5Cu, among others, which are widely used for implementing electronic parts onto printed boards. When a semiconductor element having the Ni-based metallization is bonded by using these Sn-based solders, the Ni-based metallization is consumed by the reaction between solder and the Ni-based metallization. In particular, when bonding is carried out under severe conditions such as in the assembly of power semiconductor devices, the Ni-based metallization of the semiconductor element completely disappears. Fig. 2 shows a diagram of the comparison of the tensile strengths at the interface of the bonding portion of a semiconductor element in a semiconductor device in the case where the Ni-based metallization is remaining and the case where it has disappeared. When the Ni-based metallization has disappeared, the strength at the interface of the bonding portion of the semiconductor element is significantly deteriorated than when the Ni-based metallization is remaining. Such deterioration at the bonding interface greatly affects the product's life.

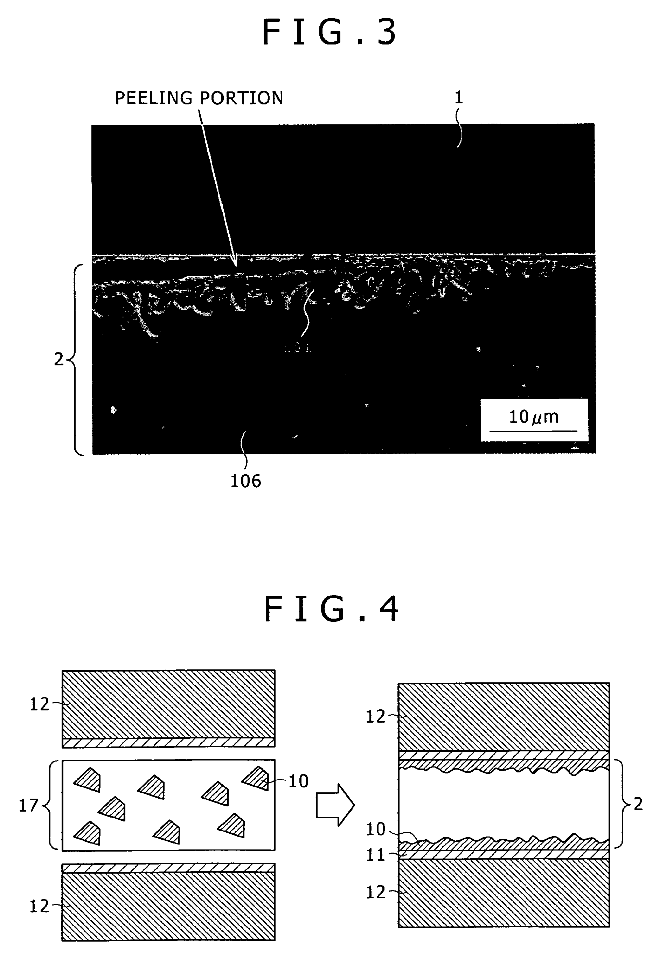

Fig. 3 shows an example of the case where the semiconductor element 1 peeled off from the bonding member 2 having an intermetallic compound layer 101 containing at least one of Cu₆Sn₅ and (Cu,Ni)₆Sn₅ compounds and a Sn-based solder 106 in a bonding reliability test. In order to prevent peeling of the semiconductor element 1, thickening the Ni-based metallization is thought to be effective, which requires forming metallization on the entire surface of a Si wafer when applied to the power semiconductor. In such a case, however, the thickness of the Ni-based metallization larger than 1 µm may cause breakage due to the warping of the semiconductor element caused by the membrane stress of the Ni-based metallization and peeling of metallization. The thickness of the Ni-based metallization of about 1 µm, which can be formed normally, cannot suppress the disappearance of the Ni-based metallization caused by the bonding of the Sn-based solder such as Sn-0.7Cu, Sn-3.5Ag and Sn-3Ag-0.5Cu.

Pb-free solder materials containing no Pb and having a melting point as high as that of a high-Pb solder include Au-based materials such as Au-20Sn (eutectic, 280°C), Au-12Ge (eutectic, 356°C) and Au-3.15Si (eutectic, 363°C), but they are extremely expensive. Au-20Sn, which has a relatively low Au content, has the disadvantage that it cannot provide sufficient stress buffering in bonding a large area since it is a hard solder and the semiconductor element is easily damaged.

Other Pb-free solder materials include Sn-based medium-temperature solders having a melting point of 200°C or higher such as Sn-3Ag-0.5Cu. They are widely used for implementing parts on a substrate, and have good bonding reliability at 150°C or lower. However, when they are retained in use under circumstances of 200°C or higher for a long period of time, interface reactions proceed at the bonding interface, and bonding reliability is disadvantageously lowered due to the formation of voids, the growth of the intermetallic compound layer and for other causes.

### To deal with this problem, for example, Japanese

Patent No. 3152945 discloses a technique for suppressing interface reactions of Sn-based solder. Japanese Patent No. 3152945 discloses "a lead-free solder alloy comprising 0.1 to 2% by weight of Cu, 0.002 to 1% by weight of Ni, and the remainder of Sn". Japanese Patent No. 3152945 reports that the consumption of Cu in the bonded material can be suppressed by adding Cu, and at the same time the growth of the intermetallic compound such as Cu₆Sn₅ and Cu₃Sn at the bonding interface can be suppressed by adding Ni. Moreover, Japanese Unexamined Patent Publication No. 2002-280417 discloses "a semiconductor device having a solder bump comprising an alloy solder on an adhesion layer containing a first metal formed at least on a wiring layer, an intermetallic compound containing a metal which is a main component of the alloy solder and a second metal which is different from the metal being formed between the solder bump and the adhesion layer".

### SUMMARY OF THE INVENTION

However, prior art inventions have the problems mentioned below, and they do not have sufficient suppression on interface reactions, and have low bonding reliability. In particular, it was found that suppression of interface reactions in a semiconductor device for on-vehicle AC generators (alternator) used at high temperatures by the prior art is difficult.

That is, in case of the above Japanese Patent No. 3152945, slight suppression of interface reactions can be expected by adding Ni, but interface reactions proceed at a high temperature of 200°C or higher since the Cu₆Sn₅ and Cu3Sn compounds are always in contact with Cu and the Sn-based solder. Accordingly, the growth of the Cu-Sn compound continues and voids and other problems are generated at the interface. This results in lowered bonding reliability.

Meanwhile, in case of Japanese Unexamined Patent Publication No. 2002-280417 mentioned above, the intermetallic compound formed closest to the solder becomes a barrier layer between the Sn-based solder and the metal layer, and therefore great effect in suppressing interface reactions can be supposedly obtained. However, it is necessary to provide two layers: a first metal layer and a second metal layer, in advance on the bonded material, entailing the problems that the number of plating steps is increased; costs are increased by carrying out selective local plating; and formation of metal layers is difficult in case of a structure which prevents formation of electrodes. Moreover, the metal layer formed on the outermost surface of the bonding face needs to be reacted with Sn-based solder in bonding to provide a barrier layer. Therefore, when the metal layer formed on the outermost surface is thick, the unreacted metal layer on the outermost surface remains in bonding, which may create the problems that the effect of the barrier layer cannot be sufficiently obtained, and that adjustment of the process such as extending the bonding time to completely allow the metal layer on the outermost surface to react need to be made. On the other hand, when the metal layer on the outermost surface is thin, the barrier layer for suppressing interface reactions becomes thin, and therefore interface reactions may not be sufficiently suppressed at a high temperature of 200°C or higher. When unreacted portions of the layer formed on the outermost layer of the bonding faces in reactions with the Sn-based solder (e.g., Cu layer) are remaining exposed and, oxidation and corrosion disadvantageously occur from the exposed portions. In contrast, when one tries to locally provide the outermost layer of the bonding faces by local plating or other means in order to avoid the remaining of the outermost layer of the bonding faces, the Sn-based solder may migrate into the metal layer (e.g., Ni layer) lying therebelow this time. In this case, an intermetallic compound (e.g., Ni-Sn compound) is formed between these layers, and interface reactions may proceed in this portion, possibly producing voids due to a change in volume.

An object of the present invention is to provide an environmental friendly bonding material of a semiconductor element at low costs, which can maintain bonding reliability even if it is used at a temperature as high as 200°C or higher for a long period of time, and to provide a semiconductor device and an on-vehicle AC generator using the bonding material.

Among the inventions disclosed in the present application for achieving the above object, a summary of a typical one will be described as follows: (1) A semiconductor device having a semiconductor element, a supporting electrode body bonded to a first face of the semiconductor element via a first bonding member, and a lead electrode body bonded to a second face of the semiconductor element supported by the supporting electrode body via a second bonding member, the semiconductor device having a Ni-based plating layer and an intermetallic compound layer containing at least one of Cu₆Sn₅ and (Cu,Ni)₆Sn₅5 compounds at an interface between the supporting electrode body and the first bonding member, and having a Ni-based plating layer and an intermetallic compound layer containing at least one of Cu₆Sn₅ and (Cu,Ni)₆Sn₅ intermetallic compounds at an interface between the lead electrode body and the second bonding member, and the intermetallic compound layer having a mean particle diameter of 4.8 µm or larger.

### BRIEF DESCRIPTION OF THE DRAWINGS

Embodiments of the present invention will be described in detail with reference to the following drawings, wherein:
Fig. 1 is a drawing which shows an example of a method for manufacturing a power semiconductor module using the bonding material of the present invention;
Fig. 2 is a drawing comparing the tensile strengths at the interfaces of the bonding portions of semiconductor elements;
Fig. 3 is a drawing showing an example that the semiconductor element peeled off from the bonding member during a bonding reliability test;
Fig. 4 is a cross-sectional view which schematically shows the bonding mechanism of the present invention;
Fig. 5A is a drawing showing the relationship between the mean crystal particle diameters of the Cu₆Sn₅ or (Cu,Ni)₆Sn₅ compound and the amount of disappearance of the Ni-based metallization;
Fig. 5B is a drawing showing the relationship between the mean crystal particle diameter of the Cu₆Sn₅ or (Cu,Ni)₆Sn₅ compound and the amount of disappearance of the Ni-based metallization;
Fig. 5C is a drawing showing the relationship between the mean crystal particle diameter of the Cu₆Sn₅ or (Cu,Ni)₆Sn₅ compound and the amount of disappearance of the Ni-based metallization;
Fig. 5D is a drawing showing the relationship between the mean crystal particle diameter of the Cu₆Sn₅ or (Cu,Ni)₆Sn₅ compound and the amount of disappearance of the Ni-based metallization;
Fig. 5E is a drawing showing the relationship between the mean crystal particle diameter of the Cu₆Sn₅ or (Cu,Ni)₆Sn₅ compound and the amount of disappearance of the Ni-based metallization;
Fig. 6 is a Sn-Cu two-phase diagram;
Fig. 7 is a drawing which shows an example of the form of providing of the bonding material;
Fig. 8 is a drawing which shows an example of the form of providing of the bonding material;
Fig. 9 is a drawing which shows an example of the bonding interface of the semiconductor element;
Fig. 10 is a drawing which shows an example of the bonding interface of the semiconductor element;
Fig. 11 is a drawing showing the amount of Cu contained in the bonding portion and the proportion of the (Cu,Ni)₆Sn₅ compound having a large amount of Ni replacement in the intermetallic compound formed on the Ni-based metallization;
Fig. 12 is a drawing showing an example of the semiconductor device for an on-vehicle AC generator using the bonding material of the present invention;
Fig. 13 is a drawing showing an example of the semiconductor device for an on-vehicle AC generator using the bonding material of the present invention;
Fig. 14 is a drawing showing the relationship between the Young's modulus and yield stress;
Fig. 15 is a drawing showing an example of the semiconductor device using the bonding material of the present invention;
Fig. 16 is a drawing showing an example of the semiconductor device using the bonding material of the present invention; and
Fig. 17 is a drawing showing an example of the semiconductor device using the bonding material of the present invention.

### DETAILED DESCRIPTION OF THE INVENTION

According to the present invention, an environmental friendly semiconductor device having heat resistance of 200°C or higher can be provided.

To begin with, the bonding material and bonding mechanism of the present invention will be described with reference to Fig. 4.

An example of the bonding material of the present invention an Sn-based solder foil 17 containing a phase 10 of a Cu-Sn compound (e.g., Cu₆Sn₅) at a temperature from room temperature to 200°C. By bonding bonded materials 12 on which a Ni-based plating 11 is formed using this solder foil 17, Cu₆Sn₅ phases 10 floating in the solder foil 17 as phases deposit or move onto the Ni-based platings 11, so that compound layers 10 mainly composed of a Cu-Sn compound (Cu₆Sn₅ phase) are formed. Herein, when the compound layers are formed, the Ni platings 11 are partly fused to form a (Cu,Nu)₆Sn₅ compound in some cases. In this case, the compound layers 10 become intermetallic compound layers containing at least one of the Cu₆Sn₅ compound and (Cu,Ni)Sn₆ compound. As a result, as shown in Fig. 4, the bonded materials 12 are bonded via bonding members 2 which are intermetallic compound layers containing at least one of the Cu₆Sn₅ compound and (Cu,Ni)Sn₆ compound, providing a constitution in which solder and the unreacted Ni-based metallization are remaining between the bonding member 2 and the bonded material 12 as a metallization. As a result, even if it is exposed to a high temperature of 200°C or higher for a long period of time, the compound layer 10 mainly composed of the Cu-Sn compound and/or (Cu,Ni)Sn₆ compound serves as a barrier layer for the Ni-based plating 11 and the Sn-based solder, and the growth of the compound layer due to a reaction at the bonding interface and the formation of voids associated with the growth can be suppressed.

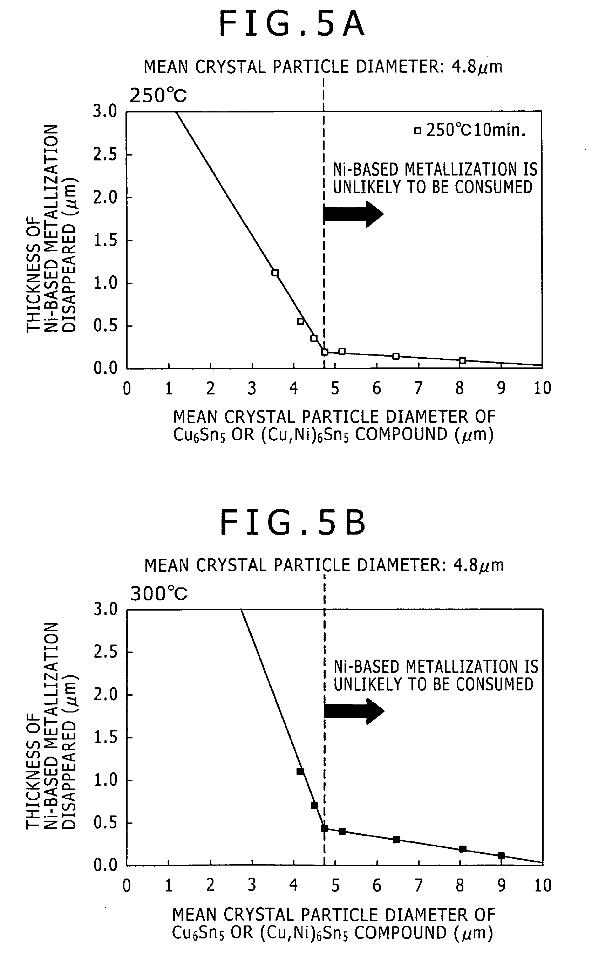

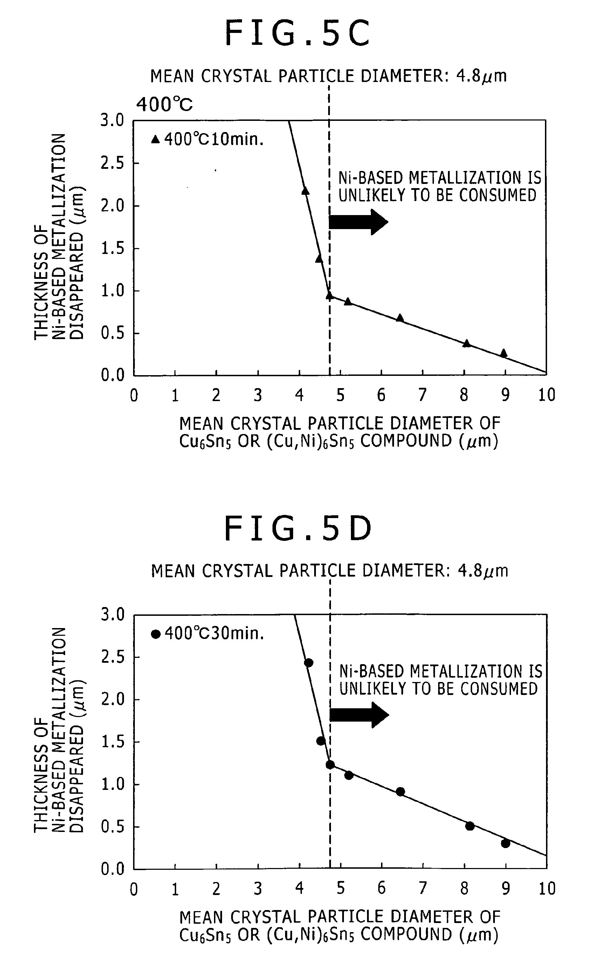

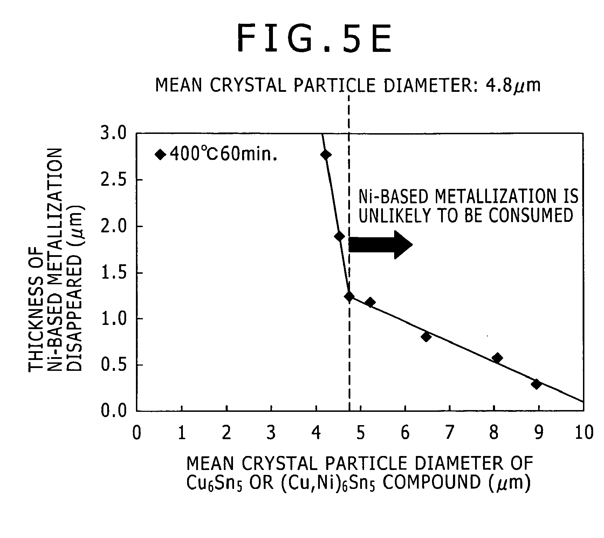

However, the particle diameter of the intermetallic compound layer containing at least one of the Cu₆Sn₅ compound and (Cu,Ni)Sn6 compound depends on the underlayer, i.e., the Ni-based metallization, and therefore becomes minute. Fig. 5 shows the relationship between the crystal particle diameter of the intermetallic compound layer containing at least one of the Cu₆Sn₅ and (Cu,Ni)₆Sn₅ intermetallic compounds formed on the Ni-based metallization and the amount of disappearance of the Ni-based metallization. Figs. 5A to 5E show the thicknesses of disappearance of the Ni-based metallization when heated at the bonding temperatures of 250°C, 300°C and 400°C, respectively. These drawings indicate that the Ni-based metallization easily disappears when the crystal particle diameter of the compound obtained by observing the cross sections of the bonding portions is smaller than 4.8 µm.

In contrast, in cases where the crystal particle diameter of the compound is 4.8 µm or larger, as can be seen from the cases of bonding times of 10 min. and 30 min. at 400°C, the disappearance of the Ni-based metallization is greatly suppressed. The intermetallic compound layer containing at least one of the Cu₆Sn₅ compound and the (Cu,Ni)₆Sn₅ compound and having a crystal particle diameter of 4.8 µm or larger is formed by bonding at a temperature from the liquid phase linear temperature of the solder to 10°C or lower using the Sn-based solder containing Cu in an amount of 4 wt.% or higher.

According to the bonding mechanism of this embodiment, the bonded material need only be provided with at least one layer of Ni plating such as Ni, Ni-P and Ni-B, thereby enabling bonding with less steps. Moreover, according to the bonding mechanism of the present invention, the thickness of the barrier layer formed depends on the amount of the Cu-Sn compound phase contained in the solder foil, whereby the thickness of the barrier can be adjusted by increasing or decreasing the amount of the Cu-Sn compound. Furthermore, as shown in Fig. 4, the Cu-Sn compound 10 in the solder at the bonding interface which is wet with the solder is positively deposited on or moves onto the Ni-based plating 11, and the barrier layer of the Cu-Sn compound is formed. Therefore, the problem described above does not occur in the bonding portion after being bonded.

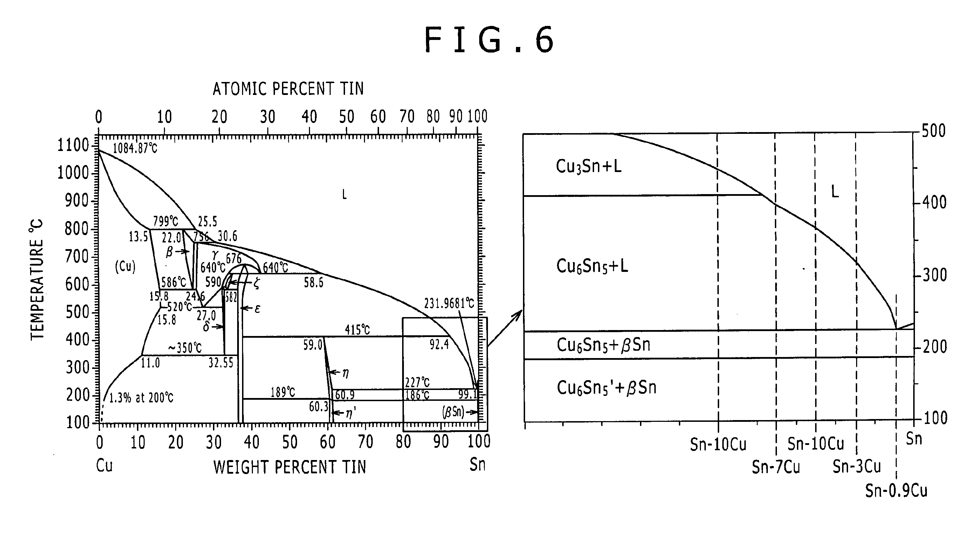

Herein, as the bonding material of the present invention, the conditions under which that the Cu-Sn compound is contained as phases and the Sn-based solder contains Cu₆Sn₅ at a temperature from room temperature to 200°C will be described with reference to Fig. 6 which shows a Sn-Cu two-phase diagram.

In the composition containing less Cu than Sn-0.9Cu, when the solder is fused and solidified, Sn, which is contained in an amount higher than that of the eutectic composition, is first deposited as a primary phase, and finally Sn and Cu₆Sn₅ are solidified as a eutectic structure. At that time, since Cu₆Sn₅ is deposited in a state of being dispersed at the grain boundary and the like inside the bonding portion, it is not deposited on the Ni-based plating in the form of a barrier layer. Accordingly, heat resistance cannot be obtained. In contrast, in the composition containing Cu in an amount higher than Sn-0.9Cu, when the solder is fused and solidified, the Cu₆Sn₅ phase is first deposited. At this time, since Cu₆Sn₅ is deposited preferentially on the Ni-based plating, the barrier layer of the Cu-Sn compound is formed. Finally, Sn and Cu₆Sn₅ are then solidified as the eutectic structure. The barrier layer of the Cu-Sn compound is formed by the mechanism as mentioned above.

That is, the composition containing the Cu₆Sn₅ phase in an amount higher than the eutectic composition may be selected as the bonding material of the present invention. In the Sn-Cu two-phase system, Cu need only be contained in an amount of 0.9 wt.% or higher, but the eutectic composition varies depending on the alloy system when other elements are contained. Therefore, in either case, a bonding material having the composition containing the Cu₆Sn₅ phase in an amount higher than that in the eutectic composition may be selected. In case of Sn-3Ag-0.5Cu and Sn-0.7Cu normally used in this composition, the amount of Cu₆Sn₅ phase is lower than that in the eutectic composition, and therefore no barrier layer is formed on the Ni-based plating.

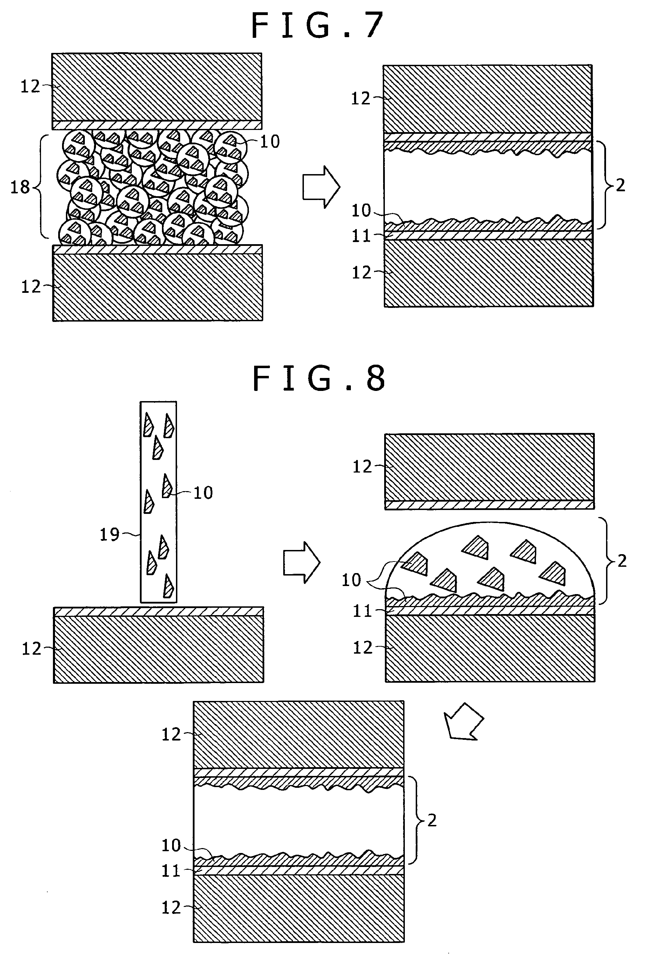

Although the bonding material of the present invention and its bonding mechanism have been described above, the form of providing of the bonding material is not critical on foil, and as shown in Figs. 7 and 8, even when it is provided in the form of pastes, wires or any other forms, a barrier layer of the Cu-Sn compound and/or (Cu,Ni)Sn₆ compound on the Ni-based plating is formed after bonding. A providing method suitable for the bonding circumstances can be selected. In Fig. 7, the bonded materials 12 are bonded with the solder paste 18 having the Cu-Sn compound 10 as a solder material so that the bonding member 2 is formed. In Fig. 8, the bonded materials 12 are bonded with the solder wire 19 having the Cu-Sn compound 10 as a solder material so that the Cu-Sn compound 10 is deposited.

Since the Sn-based solder containing the Cu₆Sn₅ phase at a temperature from room temperature to 200°C has good wettability, the composition having a liquid phase linear temperature which is preferably the bonding temperature or lower may be selected.

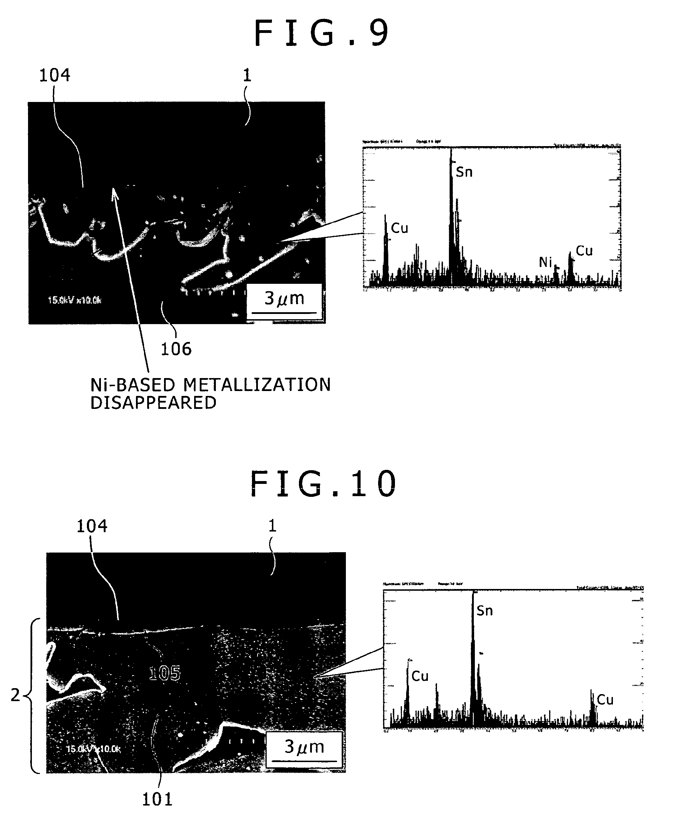

Figs. 9 and 10 show an example of the bonding interface between semiconductor elements when the mean particle diameter is smaller than 4.8 µm and when it is 4.8 µm or larger. The Ni-based metallization has disappeared when the mean particle diameter of the intermetallic compound containing at least one of the Cu₆Sn₅ and (Cu,Ni)₆Sn₅ compounds is smaller than 4.8 µm, while the Ni-based metallization has not disappeared but has remained when it is 4.8 µm or larger. Fig. 9 shows that the semiconductor element 1, the intermetallic compound layer 101 containing at least one of the Cu₆Sn₅ and (Cu,Ni)₆Sn₅ compounds and Sn-based solder 106 are bonded via a non-Ni-based metallization 104, indicating the disappearance of the Ni-based metallization.

When the mean particle diameter is smaller than 4.8 µm, the (Cu,Ni)₆Sn₅ compound containing a large amount of Ni largely occupies the intermetallic compound layer. Therefore, even if the intermetallic compound layer-containing at least one of the (Cu,Ni)₆Sn₅ compounds exists on the Ni-based metallization in bonding, Ni likely diffuses through the intermetallic compound, and the disappearance of the Ni-based metallization in bonding the solder cannot be sufficiently suppressed. Moreover, when the crystal grains are minute, the proportion of the boundaries of crystal grains increases. Since the rate of diffusion is higher at the boundaries of crystal grains than in the grains, the more minute the crystal grains, the more likely Ni diffuses.

On the other hand, in Fig. 10, the semiconductor element 1 and the bonding member 2 having the intermetallic compound layer 101 containing at least one of the Cu₆Sn₅ and (Cu,Ni)₆Sn₅ compounds and the Ni-based metallization 105 are bonded via the non-Ni-based metallization 104. Since the intermetallic compound layer containing at least one of the Cu₆Sn₅ and (Cu,Ni)6Sn5 compounds formed on the Ni-based metallization and having a mean particle diameter of 4.8 µm or larger is largely occupied by the Cu₆Sn₅ compound or the (Cu,Ni)₆Sn₅5 compound with low Ni contents, the diffusion of Ni through the intermetallic compound is slowed. Moreover, the larger the crystal particle diameter, the lower the proportion of grain boundaries, which prevents diffusion of Ni, and therefore it functions as a diffusion barrier layer of the Ni-based metallization in bonding the solder.

Moreover, it is desirable that the intermetallic compound layer containing at least one of Cu₆Sn₅ and (Cu,Ni)₆Sn₅ compounds having a mean crystal particle diameter of 4.8 µm or larger does not contain Cu3Sn. In case where Cu3Sn is present in the intermetallic compound layer, when heat is generated when the power semiconductor device is energized, or when the semiconductor device is used under high heat circumstances of 150°C or higher, Cu3Sn is transformed into Cu₆Sn₅ or (Cu,Ni)₆Sn₅. Therefore, Kirkendall voids and voids associated with the change in volume are produced in the vicinity of the bonding interface, whereby bonding reliability cannot be obtained. Due to the reaction between the Ni-based metallization and the Sn-based solder, forming the intermetallic compound layer containing at least one of the Cu₆Sn₅ and (Cu,Ni)₆Sn₅ compounds on the Ni-based metallization very likely causes unreacted Cu and Cu3Sn compounds to remain locally.

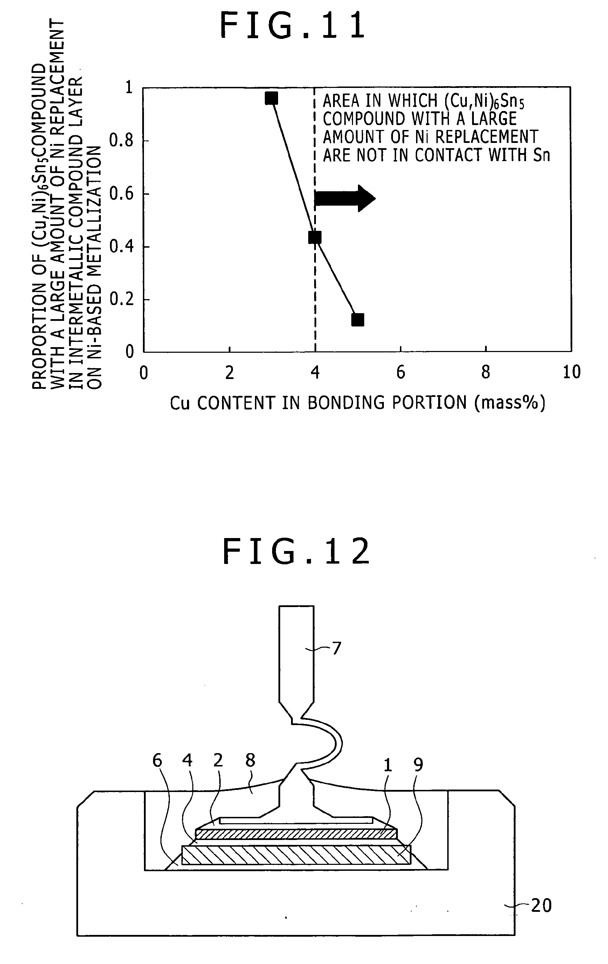

It is desirable that the amount of Cu contained in the intermetallic compound and the solder portion in total is 4 mass % or higher. In case of the bonding portion having the intermetallic compound with a mean crystal particle diameter smaller than 4.8 µm and the amount of Cu contained in the intermetallic compound and the solder portion in total lower than 4 mass %, the disappearance of the Ni-based metallization of the semiconductor element in bonding cannot be suppressed. Fig. 11 shows the amount of Cu contained in the bonding portion and the proportion of the (Cu,Ni)₆Sn₅ compound having a large amount of Ni replacement in Fig. 9 in the intermetallic compound formed on the Ni-based metallization. The lower the amount of Cu contained in the bonding portion, the higher the proportion of the (Cu,Ni)₆Sn₅ compound having a large amount of Ni replaced. When the amount of Cu contained in the bonding portion is lower than 4 mass %, the contact between the (Cu,Ni)₆Sn₅ compound having a large amount of Ni replacement and Sn promotes diffusion of Ni, whereby suppression of the disappearance of the Ni-based metallization is difficult. In contrast, when the amount of Cu contained is 4 mass % or higher, the Cu₆Sn₅ compound or (Cu,Ni)₆Sn₅ having a low amount of Ni replacement in Fig. 10 is present between Sn and the (Cu,Ni)₆Sn₅5 compound having a large amount of Ni replacement, whereby the disappearance of the Ni-based metallization can be suppressed effectively.

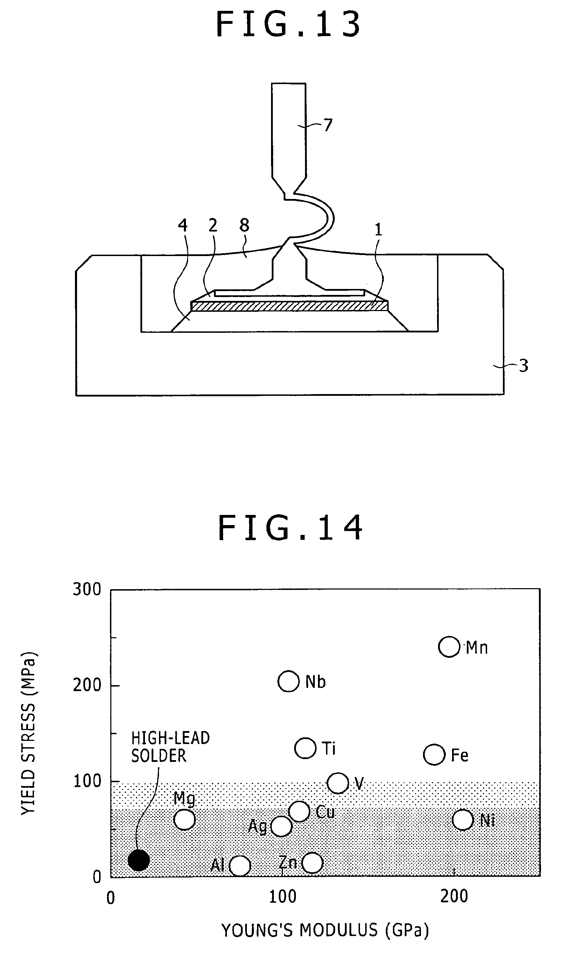

Next, an embodiment of a semiconductor device using the bonding material of the present invention and a method for manufacturing the same will be described with reference to Figs. 12 and 13 showing a semiconductor device for on-vehicle AC generators.

The semiconductor device shown in Fig. 12 has a semiconductor element 1, a lead electrode body 7 having a Ni-based plating provided on a bonding portion bonded to a first face of the semiconductor element 1 via a bonding member 2 formed using the bonding material of the present invention, a coefficient of thermal expansion difference buffer 9 having a Ni-based plating provided on a bonding portion bonded to a second face of the semiconductor element 1 via a bonding member 4 by using the bonding material of the present invention, and a supporting electrode body 20 having a Ni-based plating provided on a bonding portion bonded to the other face of the coefficient of thermal expansion difference buffer 9 via a bonding member 6 bonded by using the bonding material of the present invention.

By conducting bonding using the bonding material of the present invention, reactions at the interface can be suppressed even during use at high temperatures, thereby providing a semiconductor device having bonding reliability.

Although other materials can be partially used without using the bonding material of the present invention in all the bonding portions, it is preferable that the bonding material of the present invention is used in all the bonding portions from the perspective of bonding reliability. At this time, any material can be used as long as it is the bonding material having the composition containing the Cu₆Sn₅ phase in an amount higher than that in the eutectic composition and/or the (Cu,Ni)Sn₆ compound, and it may be different from each other in the bonding portions.

Herein, any one of Al, Mg, Ag, Zn, Cu and Ni can be used as the coefficient of thermal expansion difference buffer 9. These are metals with small yield stress, and are easily deformed by inertia. To this end, by applying these metals to the bonding portions, the stress generated in the bonding portions by the coefficient of thermal expansion difference in the bonded material during cooling after being bonded and during heat cycle can be buffered.

At this time, as shown in Fig. 14, the yield stress is preferably 75 MPa or lower. This is because when the yield stress is 100 MPa or higher, the stress cannot be sufficiently buffered, and cracks may be generated in the semiconductor element. It is preferable that the thickness is 30 to 500 µm. When the thickness is not more than 30 µm, the stress cannot be sufficiently buffered, and cracks may be generated in the semiconductor element and intermetallic compound. When the thickness is 500 µm or more, the effect of coefficient of thermal expansion may be increased and the reliability may be lowered since Al, Mg, Ag and Zn have coefficients of thermal expansion higher than an electrode made of Cu.

As the coefficient of thermal expansion difference buffer 9, any one of Cu/invar alloy/Cu composite material, Cu/Cu2O composite material Cu-Mo alloy, Ti, Mo and W can be used. Due to this coefficient of thermal expansion difference buffer 9, the stress caused by the coefficient of thermal expansion difference between the semiconductor element and the Cu electrode generated in bonding during heat cycle and during cooling after being bonded can be buffered. At this time, when the thickness is too small, the stress cannot be sufficiently buffered, and cracks may be generated in the semiconductor element and intermetallic compound. Therefore, the thickness is preferably 30 µm or more.

Since the Sn-based solder has a thermal conductivity higher than a high-lead solder, the resistance of the semiconductor device can be lowered and its heat radiation can be increased. As in Fig. 13, the coefficient of thermal expansion buffer 9 can be thus omitted, but it is preferably inserted in order to obtain sufficient bonding reliability even when the Sn-based solder which is harder than the high-lead solder is used.

As the Ni-based plating to be provided on the bonded materials, Ni, Ni-P, Ni-B and the like may be used as mentioned above, and Au plating, Ag plating and Pd plating may be further provided on the platings. This can improve wettability. In that case, the plating layers such as Au and Ag are all diffused within the solder during bonding, whereby the barrier layer of the Cu-Sn compound can be formed on the Ni-based plating of the underlayer. Moreover, at least one metallization layer of Ti, Pt, Cr and V may be provided beneath the Ni-based metallization layer. Even when at least one metallization layer of Ti, Pt, Cr and V is provided beneath the Ni-based metallization layer, providing the Ni-based metallization layer thereon forms the intermetallic compound layer having at least one of the stable Cu₆Sn₅ and (Cu,Ni)₆Sn₅ compounds at the bonding interface.

Next, the method for manufacturing the semiconductor device will be described. The components and bonding members are layered as shown in Fig. 12 in the following order: that is, on the supporting electrode body 20, a Sn-based solder foil 6 containing Cu₆Sn₅ phases at a temperature from room temperature to 200°C, a coefficient of thermal expansion difference buffer 9 of a Ni plating CIC (Cu/lnver/Cu) clad metal having a coefficient of thermal expansion of 11x10⁻⁶/°C, a diameter of 6.8 mm and a thickness of 0.6 mm, a Sn-based solder foil containing Cu₆Sn₅ phases at a temperature from room temperature to 200°C, a Ni plating semiconductor element 1 having a diameter of 6 mm and a thickness of 0.2 mm, a Sn-based solder foil containing Cu₆Sn₅ phases at a temperature from room temperature to 200°C, and a Cu lead electrode body 7 with a Cu plate having a diameter of 4.5 mm and a thickness of 0.2 mm. The combined layers are placed in a positioning fixture, and are bonded in a reducing atmosphere prepared by mixing 50% hydrogen into nitrogen in a heat treat furnace and under the temperature condition of 380°C for one minute. Subsequently, a silicone rubber 8 is injected near the bonding portions and cured, giving a semiconductor device. The bonding procedure can be carried out well without using flux when it is conducted at 220 to 450°C in a reducing atmosphere. At this time, the solder bonding material is desirably Sn-4 to 10Cu (mass %). By bonding a semiconductor element having the Ni-based metallization using Sn-4 to 10Cu (mass %), the intermetallic compound containing at least one of Cu₆Sn₅ compound and the (Cu,Ni)₆Sn₅ compound having a mean crystal particle diameter of 4.8 µm or larger is crystallized and deposited on the Ni-based metallization, or Cu₆Sn₅ which is present in the solder like floating islands is deposited on the Ni-based metallization by convection or the like, whereby a diffusion layer can be formed. By carrying out bonding at a temperature of the solid phase linear temperature or higher and 20°C higher than the liquid phase linear temperature, bonding without causing the Ni-based metallization of the semiconductor element to disappear is made possible. Moreover, when the temperature is equal to or higher than the liquid phase linear temperature, the fused solder is likely to come into contact with the Ni-based metallization. It is therefore preferable to carry out bonding at the liquid phase linear temperature or lower. Good wettability and low void fraction can be both achieved by carrying out bonding in a reducing atmosphere.

Another form of a method for manufacturing a power semiconductor module using the bonding material of the present invention will be now described with reference to Fig. 1.

Using a fixture which prevents a shift in position as shown in Fig. 1, bonding was carried out in a reducing atmosphere by the following procedure: Sn-(4-10)Cu (mass %) 2 foils are laminated on the substrate 3; the power semiconductor element 1 is then laminated thereon; and the intermetallic compound layer containing at least one of the Cu₆Sn₅ and (Cu,Ni) ₆Sn₅ compound layers having a mean particle diameter of 4.8 µm is formed on the Ni-based metallization. Bonding was then carried out by an Al wire 21 between the electrodes on the semiconductor element 1 and on the substrate 3. This was subjected to bonding by laminating a Sn-based solder foil on the supporting member 5 and the substrate having the semiconductor element 1 mounted thereon using a fixture which presents a shift in position, in a reducing atmosphere at 300°C for 10 min. After the electrode on the substrate 3 and an external electrode are connected by the Al wire 21, a gel was injected near the bonding portion and cured, and a case was attached thereto, producing a semiconductor device.

The state of the Ni-based metallization remaining in the semiconductor element after this semiconductor device was assembled was examined by observing its cross section and by nondestructive testing with ultrasound wave. The results are shown in Table 1. The case where 90% or more of Sn and the unreacted Ni-based metallization is remaining relative to the area of the bonding portions is indicated by o, while the case where less than 90% is remaining is indicated by x. In all of Examples 1 to 16, it was confirmed that 90% or more of the Ni-based metallization was remaining relative to the area of the bonding portion.

**Table 1**

| EXAMPLE No. | CRYSTAL PARTICLE SIZE OF COMPOUND | METALLIZATION OF SEMICONDUCTOR ELEMENT | | BONDING TEMPERATURE | BONDING TIME | STATE OF Ni-BASED METALLIZATION REMAINING |
|---|---|---|---|---|---|---|
| | | TYPE | THICKNESS | | | |
| | (µm) | | (µm) | (°C) | (min.) | |
| 1 | 6.5 | Ni | 0.5 | 300 | 10 | ○ |
| 2 | 6.5 | Ni-P | 0.5 | 300 | 10 | ○ |
| 3 | 6.5 | Ni/Flash Au | 0.5 | 300 | 10 | ○ |
| 4 | 8.1 | Ni | 0.5 | 300 | 10 | ○ |
| 5 | 8.1 | Ni-P | 0.5 | 300 | 10 | ○ |
| 6 | 8.1 | Ni/Flash Au | 0.5 | 300 | 10 | ○ |
| 7 | 6.5 | Ni/Flash Au | 0.5 | 275 | 10 | ○ |
| 8 | 6.5 | Ni/Flash Au | 0.5 | 325 | 10 | ○ |
| 9 | 8.1 | Ni/Flash Au | 0.5 | 275 | 10 | ○ |
| 10 | 8.1 | Ni/Flash Au | 0.5 | 325 | 10 | ○ |
| 11 | 6.5 | Ni/Flash Au | 1.0 | 300 | 5 | ○ |
| 12 | 6.5 | Ni/Flash Au | 1.0 | 300 | 10 | ○ |
| 13 | 6.5 | Ni/Flash Au | 1.0 | 300 | 15 | ○ |
| 14 | 8.1 | Ni/Flash Au | 1.0 | 300 | 5 | ○ |
| 15 | 8.1 | Ni/Flash Au | 1.0 | 300 | 10 | ○ |
| 16 | 8.1 | Ni/Flash Au | 1.0 | 300 | 15 | ○ |
| COMPARATIVE EXAMPLE | | | | | | |
| 1 | 3.5 | Ni/Flash Au | 0.5 | 300 | 10 | × |
| 2 | 3.5 | Ni/Flash Au | 0.5 | 275 | 10 | × |
| 3 | 3.5 | Ni/Flash Au | 0.5 | 325 | 10 | × |
| 5 | 3.5 | Ni/Flash Au | 1.0 | 300 | 5 | × |
| 6 | 3.5 | Ni/Flash Au | 1.0 | 300 | 10 | × |
| 7 | 3.5 | Ni/Flash Au | 1.0 | 300 | 15 | × |

Although the process of producing the overall structure is divided in two separate processes: bonding the semiconductor device and the substrate; and bonding the substrate and the supporting member in the description above, the bonding can be conducted by one process after the semiconductor element, solder foils, substrate, solder foil and supporting member are laminated.

### (Comparative Examples 1-7)

The bonding structure is the same as in Examples 1-16. The state of the Ni-based metallization remaining in the semiconductor element after this semiconductor device was assembled was examined by observing its cross section and by nondestructive testing with ultrasound wave. The results are shown in Table 1. The case where 90% or more of Sn and the unreacted Ni-based metallization was remaining relative to the area of the bonding portions is indicated by ○, while the case where less than 90% was remaining was indicated by ×. In all of Comparative Examples 1-7, the proportions of the areas of the bonding portions of the Ni-based metallization remaining in the semiconductor element were less than 90%. The areas of the Ni-based metallization remaining in all the materials were about 20%.

Although the invention made by the inventors of the present invention has been specifically described above with reference to embodiments, the present invention is not limited to the above embodiments, and it would be obvious that various changes can be made without departing from the spirit of the invention.

That is, although the application of the present invention is described by taking a semiconductor element of a power module as an example in the above, applicable semiconductor devices are not necessarily limited to alternators, and it can be applied to all bonding using a Sn-based solder as well.

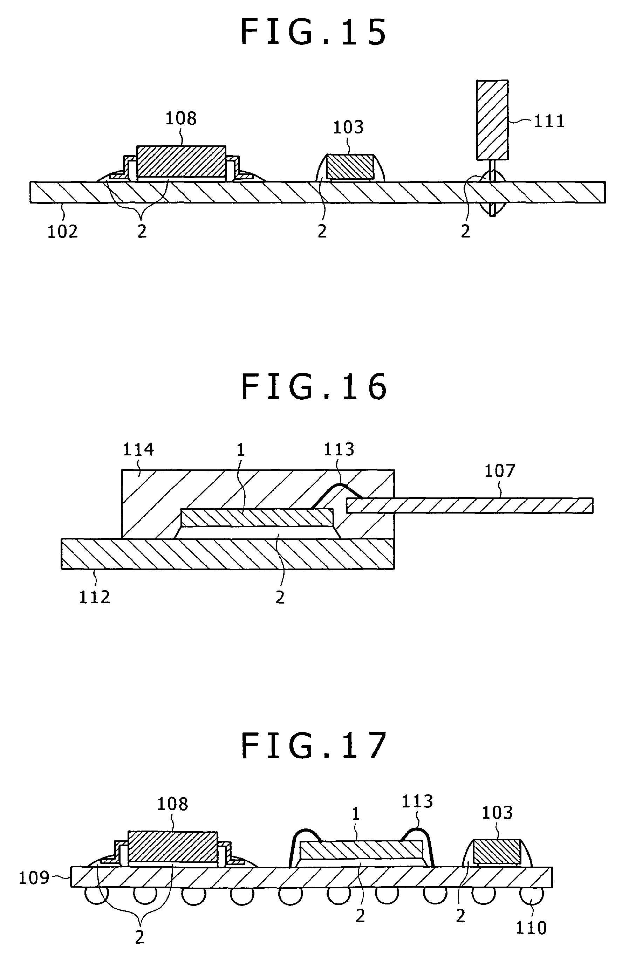

Another form of a semiconductor device using the bonding material of the present invention will be now described with reference to Fig. 15. Fig. 15 is an example of parts implementation onto a printed board. It has a printed board 102, a surface mount device 108 which is bonded to and implemented on the printed board 102 using the bonding material of the present invention, a chip part 103 bonded to and implemented on the printed board 102 using the bonding material of the present invention, and a through-hole mount device 111 bonded to and implemented on the printed board 102 using the bonding material of the present invention. Although not shown, Ni-based plating is provided on the surfaces bonded. By implementing using the bonding mechanism of the present invention, reactions at the interface can be suppressed even at high temperatures, and a semiconductor device with high bonding reliability can be provided.

When bonding is carried out using a substrate with the semiconductor element mounted thereon as a base, the bonding portions of the semiconductor element are re-fused. The disappearance of the Ni-based metallization can be suppressed by similar effects also at this time.

Although the surface mount device 108, chip part 103 and through-hole mount device 111 are all implemented in Fig. 15, only one or two of them need only be implemented. Moreover, other solder materials such as Sn-3Ag-0.5Cu may be used in some bonding.

Another form of a semiconductor device using the bonding material of the present invention will be now described with reference to Fig. 16.

The semiconductor device shown in Fig. 16 has a semiconductor element 1, a frame 112 bonded to the semiconductor element 1 by using the bonding material of the present invention, an external lead 107 electrically connected by an electrode (not shown) provided on the semiconductor element 1 and a wire 113, and a mold resin 114 provided in a manner of covering the semiconductor element 1. Although not shown, Ni-based plating is provided on the surfaces bonded. By using the bonding mechanism of the present invention, reactions at the interface can be suppressed even at high temperatures, and a semiconductor device with high bonding reliability can be provided.

Another form of the semiconductor device will be described with reference to Fig. 17.

The semiconductor device shown in Fig. 17 is a structure typically including RF module and the like, and has a module substrate 109, a surface mount device 108 bonded to the module substrate by using the bonding material of the present invention, a semiconductor element 1 bonded to the module substrate by using the bonding material of the present invention, a chip part 103 bonded to the module substrate by using the bonding material of the present invention, and a solder ball 110 provided on the back side of the module substrate 1. Although not shown, Ni-based plating is provided on the surfaces bonded. By using the bonding mechanism of the present invention, reactions at the interface can be suppressed even at high temperatures, and a semiconductor device with high bonding reliability can be provided.

Although some embodiments of the semiconductor device have been described above, the present invention is not limited to these forms, and it would be obvious that various changes may be made without departing from the spirit of the invention. For example, it may be used for front-end modules such as power transistors, power ICs, IGBT substrates and RF modules, die bonding of power modules for automobiles, among others. Moreover, the bonding material of the present invention used for bonding may be provided in any form as long as it is a Sn-based solder with the composition containing the Cu₆Sn₅ phase in an amount higher than that in the eutectic composition, and may be provided in the leveling process of printed boards, dipping to parts, printing, and as foils and wires, among others.

## Claims

1. A semiconductor device comprising:
a semiconductor element;
a supporting electrode body bonded to a first face of the semiconductor element via a first bonding member; and
a lead electrode body bonded to a second face of the semiconductor element supported by the supporting electrode body via a second bonding member,
the semiconductor device having a Ni-based plating layer and an intermetallic compound layer containing at least one of Cu₆Sn₅ and (Cu, Ni)₆Sn₅ intermetallic compounds at an interface between the supporting electrode body and the first bonding member, and
having a Ni-based plating layer and an intermetallic compound layer containing at least one of Cu₆Sn₅ and (Cu,Ni)₆Sn₅ compounds at an interface between the lead electrode body and the second bonding member.

2. A semiconductor device comprising:
a semiconductor element;
a supporting electrode body bonded to a first face of the semiconductor element via a first bonding member; and
a lead electrode body bonded to a second face of the semiconductor element supported by the supporting electrode body via a second bonding member,
the semiconductor device having a Ni-based plating layer and an intermetallic compound layer containing at least one of Cu₆Sn₅ and (Cu,Ni)₆Sn₅ compounds at an interface between the first bonding member and the semiconductor element, and
the semiconductor device having a Ni-based plating layer and an intermetallic compound layer containing at least one of Cu₆Sn₅ and (Cu,Ni)₆Sn₅ compounds at an interface between the first bonding member and the semiconductor element.

3. The semiconductor device according to claim 1 or 2, wherein the intermetallic compound layer has a mean particle diameter of 4.8 µm or larger.

4. The semiconductor device according to any one of claims 1 to 3, wherein a coefficient of thermal expansion difference buffer is present between the supporting electrode body and the semiconductor element.

5. The semiconductor device according to claim 4, wherein the coefficient of thermal expansion difference buffer is one member of Al, Mg, Ag, Zn, Cu and Ni.

6. The semiconductor device according to claim 4, wherein the coefficient of thermal expansion difference buffer is one of a Cu/invar alloy/Cu composite material, a Cu/Cu20 composite material Cu-Mo alloy, Ti, Mo and W.

7. The semiconductor device according to any one of claims 1 to 6, wherein Ni-based plating is a plating of Ni, Ni-P or Ni-B.

8. The semiconductor device according to claim 7, wherein at least one of Au, Ag and Pd plating is further provided on the Ni-based plating.

9. An on-vehicle AC generator on which a semiconductor device according to any one of claims 1 to 8 is mounted.

10. A semiconductor device comprising:
a substrate; and
a semiconductor element bonded to the substrate via a bonding member,
the semiconductor device having a Ni-based plating layer and an intermetallic compound layer containing at least one of Cu₆Sn₅ and (Cu,Ni)₆Sn₅ compounds at an interface between the substrate and the bonding member and at an interface between the bonding member and the semiconductor element, respectively.

11. The semiconductor device according to claim 10, wherein the intermetallic compound layer has a mean particle diameter of 4.8 µm or larger.

12. The semiconductor device according to any one of claims 1, 2 and 10, wherein the bonding member is in one form of a foil, a paste and a wire.
